# FASCICULE DE BREVET EUROPEEN

(11) **EP 0 316 839 B1**
(45) Date de publication et mention de la délivrance du brevet: **25.08.1993**
(21) Numéro de dépôt: 88118946.8
(22) Date de dépôt: 14.11.1988
(51) Int. Cl.: H03G 9/02, H03G 3/20

(54) **Dispositif d'amélioration du confort d'écoute en présence d'évanouissement de porteuse dans une chaîne de réception d'un équipement FM/PM à bande étroite, notamment en radiotéléphonie**
Hörverbesserungsschaltung im Falle eines Trägerschwunds in einem schmalbandigen FM/PM-Empfänger
Listening comfort enhancer in the presence of carrier fading in an FM/PM narrow-band receiver

(30) Priorité: 19.11.1987 FR 8716011
(43) Date de publication de la demande: 24.05.1989
(73) Titulaire: ALCATEL RADIOTELEPHONE, 75008 Paris (FR)
(72) Inventeur: Genty, Gérard, F-78780 Maurécourt (FR); Varin, Joel, F-95520 Osny (FR); Belicaud, Michel, F-95130 Franconville (FR)
(74) Mandataire: Weinmiller, Jürgen

(56) Documents cités:
- WO-A-87/06072
- US-A- 3 605 018
- US-A- 4 408 098
- ELECTRONIC COMPONENTS AND APPLICATIONS, vol. 2, no. 4, août 1980, pages 215-218, Eindhoven, NL; D.J. VAN DER WAL: "Interference suppression for FM radios"
- RADIO FERNSEHEN ELEKTRONIK, vol. 28, no. 12, décembre 1982, page 814, Berlin, DD; H.P. SEIFERT: "Automatische Störaustastung beim AM-Empfang"
- PATENT ABSTRACTS OF JAPAN, vol. 1, no. 123, 17 octobre 1977, page 5059 E 77; & JP-A-52 54 352 (MATSUSHITA DENKI SANGYO K.K.) 02-05-1977

## Description

L'invention concerne un dispositif d'amélioration du confort d'écoute en présence d'évanouissement de porteuse dans une chaîne de réception d'un équipement FM/PM (modulation de fréquence/modulation de phase) à bande étroite, notamment en radiotéléphonie.

L'utilisation de la modulation FM/PM dans les équipements de radiotéléphonie entraîne l'apparition d'un certain nombre de défauts dûs aux évanouissements lents ou rapides de la porteuse, particulièrement gênants sur le plan acoustique.

Si l'on observe le signal de sortie d'une chaîne de réception FM/PM recevant une porteuse non modulée à l'entrée antenne, on constate l'existence d'impulsions qui proviennent de la combinaison vectorielle du bruit et du signal utile.

Ces phénomènes apparaîssent d'autant plus que le rapport signal à bruit est faible et ils induisent des parasites ("clicks" ou phénomènes transitoires) très désagréables dans l'écouteur ; leur apparition est aléatoire. On peut d'ailleurs les caractériser par un certain nombre de paramètres :
- Distribution statistique de leur amplitude ;
- Distribution statistique de leur durée ;
- Fréquence d'apparition.

Ces statistiques dépendent notamment des données suivantes :
- Largeur du filtre à quartz de la chaîne de réception ;
- Rapport signal à bruit à l'entrée du discriminateur de ladite chaîne.

De plus lorsqu'une chaîne de réception est utilisée dans un mobile en mouvement, il apparaît un phénomène, lié à l'existence de multitrajets, qui peut être interprété en terme de "Fading" ou d'"évanouissement périodique de porteuse". On montre que la distribution de l'amplitude du signal reçu est régie par une loi de Rayleigh. A chaque "trou de fading" dont la fréquence de récurrence est proportionnelle à la vitesse du véhicule, on aura l'apparition de "clicks" dûs à la rotation rapide du vecteur résultant bruit signal et/ou à la diminution importante du rapport signal à bruit, ainsi qu'une remontée du niveau de bruit désagréable pour l'utilisation sur le plan acoustique.

Pour corriger ces défauts, on connaît du document WO-A-87/06072, une chaîne de réception d'un équipement FM comportant un dispositif de régulation du niveau BF du signal reçu qui est situé après le discriminateur et avant le circuit d'amplification. Le document US-A-4 408 098 divulgue un circuit de contrôle adaptant la bande de fréquence du signal reçu et l'article ELECTRONIC COMPONENTS AND APPLICATIONS (vol. 2, n^{o} 4, août 1980) divulgue un circuit permettant la suppression d'interférences pour radio FM pourvu de moyens de détection et d'élimination des phénomènes transitoires.

La sensibilité des systèmes de détection de l'art connu ne permet pas la prise en compte systématiquement des "clicks", en particulier ceux de faible amplitude.

L'invention a pour objet une chaîne de réception ayant des performances optimisées telles qu'elle puisse s'intégrer dans des matériels radiotéléphoniques à bande étroite où l'espacement inter-canal est de 12,5 à 30 KHz et telles qu'elle apporte à l'utilisateur un très bon confort d'écoute, notamment pour une application au téléphone de voiture.

L'invention propose à cet effet un dispositif d'amélioration du confort d'écoute en présence d'évanouissement de porteuse dans une chaîne de réception d'un équipement FM/PM à bande étroite, notamment en radiotéléphonie, tel que défini dans la revendication 1.

L'invention permet avantageusement de réaliser une régulation du niveau d'écoute et d'adaptation du filtrage BF.

Des caractéristiques additionnelles sont définies dans la revendication 2 qui permettent d'obtenir différents avantages :
- Les conséquences audio fréquences du fading dans le cas d'un mobile qui se déplace, sont considérablement atténuées ;
- La remontée statistiquement périodique du bruit (dépendante de la vitesse du mobile), traduisant une dégradation de la qualité de la liaison, est réduite et donne à l'utilisateur un confort d'écoute accru.

De plus les différents circuits utilisés, selon l'invention, présentent de nombreux avantages, et notamment :
- Leur simplicité ;
- Leur facilité d'utilisation dans les systèmes radiotéléphones fixes ou mobiles grâce à des solutions aisément intégrables sous la forme d'un circuit intégré de faible taille.

Avantageusement l'invention comporte en outre des moyens de détection et d'élimination de phénomènes transitoires tels que définis dans la revendication 3. Ces moyens de détection et d'élimination de phénomènes transitoires permettent de remplacer lesdits phénomènes transitoires par une tension dont la valeur instantanée est celle du signal BF avant détection de ces phénomènes transitoires. Ils permettent donc de remplacer des parasites par des "blancs" quasi inaudibles.

Les caractéristiques et avantages de l'invention ressortiront d'ailleurs de la description qui va suivre, à titre d'exemple non limitatif, en référence aux figures annexées sur lesquelles :
- La figure 1 représente une chaîne de réception FM/PM ;
- La figure 2 représente un dispositif de régulation du niveau BF selon l'invention ;
- La figure 3 représente un dispositif de détection et d'élimination de phénomènes transitoires selon l'invention.

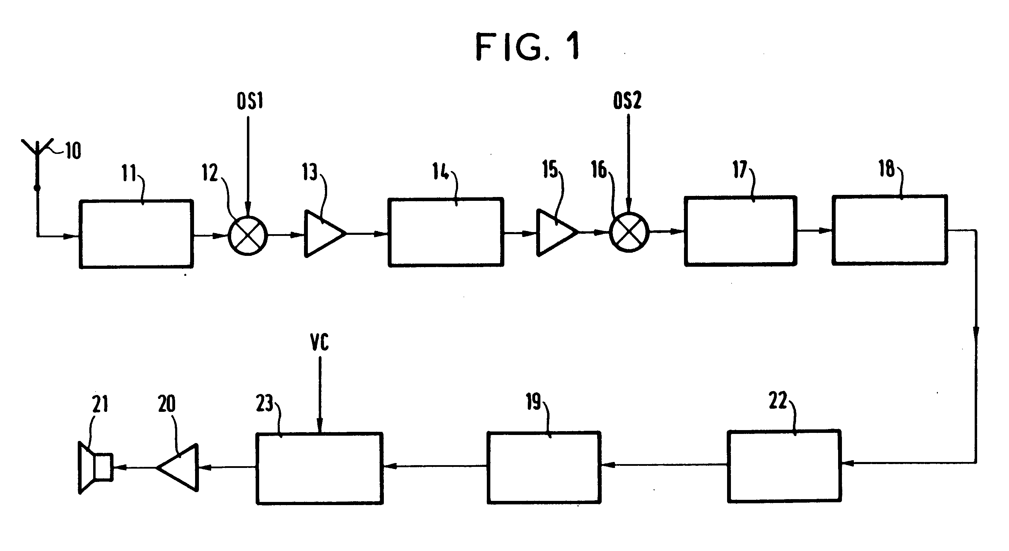

La figure 1 représente une chaîne de réception FM/PM classique (modulation de fréquence/modulation de phase) à double changement de fréquence et démodulation par discrimination de fréquence dans laquelle ont été implantés deux dispositifs selon l'invention.

Une telle chaîne de réception de l'art connu comporte :
- une tête HF 11 (hautes fréquences) située en sortie d'antenne 10 ;
- un premier mélangeur 12 à une première fréquence intermédiaire recevant un signal oscillateur OS1 ;
- un amplificateur 13 optionnel ;
- un filtre à quartz 14 ;
- un amplificateur 15 optionnel ;
- un second mélangeur 16 à une seconde fréquence intermédiaire recevant un signal oscillateur OS2 ;
- un circuit limiteur-amplificateur 17 ;
- un discriminateur 18 ;
- un éventuel circuit de désaccentuation et de filtrage BF 19 ;
- un circuit d'amplification BF (basses fréquences) 20 ;
- un haut-parleur 21.

Dans cette chaîne est implanté, selon l'invention, un dispositif permettant d'améliorer le confort d'écoute pour l'utilisateur, à savoir un dispositif 23 de régulation du niveau BF recevant un signal de commande VC qui dépend du niveau de champ reçu.

Ce dispositif 23 de régulation de niveau BF permet la régulation du niveau BF et l'adaptation du filtrage BF en présence de fading. Cette opération est possible en utilisant l'image du bruit hors bande du discriminateur 18 ou une information de champ reçu comme tension d'asservissement. Ce dispositif 23 de régulation est situé après le discriminateur 18, ce dispositif étant un circuit à bas niveau situé avant l'amplificateur BF 20.

Un second dispositif 22 est implanté dans cette chaîne. Ce dispositif 22 d'élimination de phénomènes transitoires permet de réaliser le remplacement des parasites, apparaîssant dans la chaîne réception d'un équipement, par une tension (bloqueur d'ordre O) dont la valeur instantanée est celle du signal BF avant détection du parasite. Ce dispositif 22 est situé juste après le discriminateur 18 pour réagir le plus tôt possible à l'apparition des parasites, et avant le circuit 23 de régulation de niveau BF.

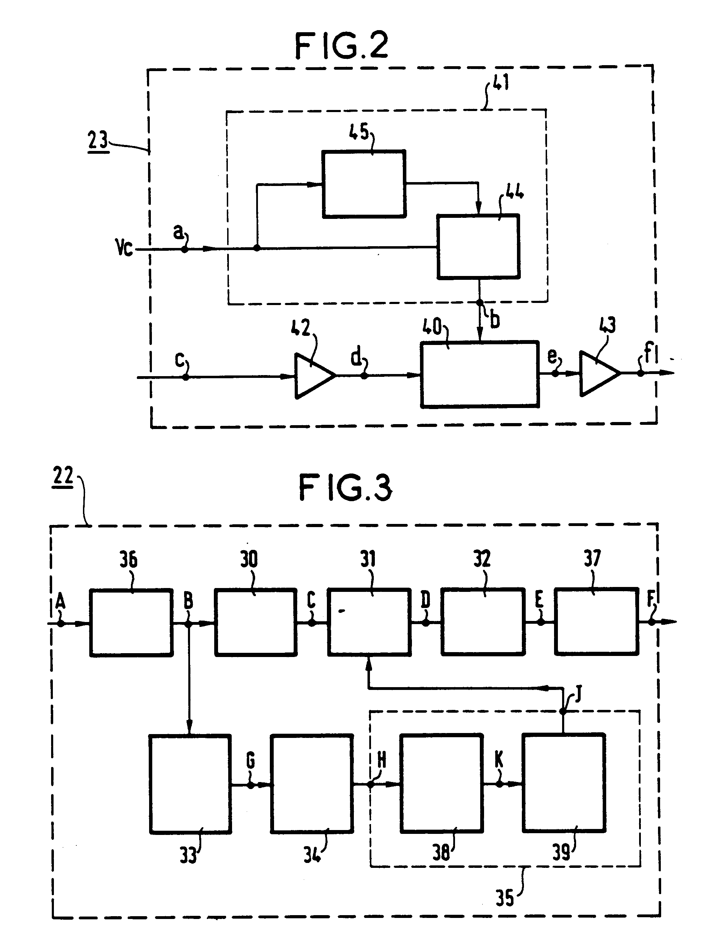

Le dispositif 23 de régulation de niveau BF, comme représenté à la figure 2, se compose de deux circuits essentiels :
- un circuit 41 de traitement du signal de commande ;
- un circuit 40 de régulation de niveau et de filtrage à bande passante adaptative.

En effet, l'amplitude du signal (utile + bruit) n'est pas constante. Elle varie en fonction du rapport signal à bruit, qui se dégrade en présence de Fading. La remontée du niveau de bruit, lors des trous de fading gêne considérablement l'écoute.

En fonction des variations de la tension représentative du champ reçu, le gain de la chaîne audiofréquence est modifié de telle sorte que le niveau moyen reste constant.

D'autre part, et simultanément, la bande passante audiofréquence est aussi asservie à l'information de champ reçu. Lorsque le champ reçu est faible, ce qui correspond à un rapport signal à bruit dégradé, la bande passante BF est alors réduite, ce qui permet l'amélioration de la qualité de la phonie. Au contraire, lorsque le rapport signal à bruit est suffisant pour assurer une bonne qualité de la phonie, le gabarit de filtrage est élargi et n'influe pas sur le filtrage originel de l'équipement.

Dans le dispositif 23 de régulation de niveau BF, l'information du niveau de champ reçu est utilisée pour effectuer la régulation du niveau et l'adaptation du gabarit de filtrage.

La valeur absolue de la mesure du champ reçu n'est pas le paramètre intéressant puisque le fading peut exister quel que soit le champ disponible à l'entrée du récepteur ; il est donc préférable d'effectuer un traitement permettant l'extraction et l'utilisation des variations relatives de la mesure de champ reçu.

Ce dispositif de régulation du niveau BF, comme représenté en figure 2, comprend :
- d'une part, entre son entrée (c) et sa sortie (f), un circuit 40 de régulation de niveau et de filtrage à bande passante adaptative ;
- et d'autre part, entre une entrée (a) tension de commande et une seconde entrée (b) du circuit de régulation de niveau (40), un circuit (41) de traitement du signal de commande.

Avantageusement ce dispositif, représenté en figure 2, comprend en outre :
- un circuit séparateur 42 disposé en entrée ;
- un circuit amplificateur 43 disposé en sortie.

Dans un exemple de réalisation, au point a est appliquée la tension Vc, image du champ reçu. Cette tension est aiguillée sur deux voies. L'une est appliquée directement à un soustracteur 44, l'autre est d'abord intégrée (45) avant d'être appliquée au soustracteur 44 précédemment cité. Cette opération réalise l'élimination de la valeur moyenne absolue du champ reçu et extrait les variations relatives de la tension image du champ reçu. Ce signal est disponible au point b.

Au point c est appliqué le signal audiofréquence. Après avoir traversé l'étage séparateur 42, le signal est appliqué à la fonction de régulation et de filtrage 40. La commande continue image du niveau de champ reçu décrite précédemment est appliquée à la fonction au point b.

Pour des variations de champ reçu de 10 décibels environ, le niveau du signal (utile + bruit) en sortie de la fonction est maintenu constant grâce au contrôle automatique de gain.

Simultanément, en fonction d'un critère de qualité de la réception déterminé par la tension d'asservissement au point b, la bande passante basse fréquence peut être réduite afin d'améliorer le rapport signal à bruit tout en conservant une intelligibilité acceptable de la communication. L'adaptation de la bande passante n'est active que dans le cas où le rapport signal à bruit est faible. Ceci correspond à une remontée importante du bruit, ce qui entraîne une sensation d'écoute difficile et désagréable.

Le signal de sortie (Point e) est ensuite appliqué à une fonction amplificatrice 43 qui permet l'ajustement du gain.

Dans les conditions normales de fonctionnement, c'est-à-dire au point neutre de la commande automatique de gain et pour un gabarit de filtrage adaptatif inactif vis-à-vis du filtrage normal du récepteur, le gain est unité entre les points c et f.

Le second dispositif 22 éliminateur de transitoires représenté à la figure 3, qui reçoit le signal issu du discriminateur de fréquence du récepteur, comprend :
- d'une part des premiers circuits connectés en série entre l'entrée (A) et la sortie (F) dudit dispositif, à savoir :
   · une ligne à retard 30 dont le temps de propagation de groupe dans la bande de fréquence 300-3000 Hz est constant et d'une valeur d'environ 150 µs, ce qui permet notamment de compenser le temps de traitement ;
   · un commutateur analogique 31 ;
   · une mémoire 32 ;
- d'autre part des seconds circuits connectés en série entre la sortie (B) du filtre passe-bas 36 et une seconde entrée du commutateur analogique 31, à savoir :
   · un circuit de détection de transitoires 33 ;
   · un redresseur double alternance 34 ;
   · une logique de commande 35 du commutateur 31 permettant de générer une fenêtre d'une largeur d'environ 500 µs dans laquelle la ligne à retard à pour rôle de centrer le parasite.

Avantageusement ce dispositif 22, représenté en figure 3, comprend en outre :
- un filtre passe-bas 36,disposé en entrée,qui permet la réjection des fréquences indésirables (Produits de mélange du récepteur par exemple) ;
- un circuit amplificateur 37 qui permet une correction de gain telle qu'en régime sinusoïdal établi une fonction de transfert de gain unité existe entre l'entrée (Point A) et la sortie (Point F) dans la gamme de fréquences 300-3000 Hz.

La logique 35 de commande du commutateur 31 peut comporter :
- un comparateur à seuil 38 ;
- un monostable redéclenchable 39 d'une durée d'environ 500 µs.

Dans un exemple de réalisation, le signal issu du discriminateur 18 de fréquence de la chaîne représentée à la figure 1 (Point A) est d'abord appliqué au filtre actif passe-bas 36, à 4 pôles, de fréquence de coupure 50 KHz. Ce filtre passe-bas 36 est composé par exemple de deux amplificateurs opérationnels (montage en source contrôlée) connectés en cascade, chaque cellule étant d'ordre 2.

Le signal (Point B) est alors appliqué à une fonction retard 30 dont le temps de propagation de groupe dans la bande de fréquence 300-3000 HZ est constant et d'une valeur d'environ 150 µs. Ce retard permet, d'une part, de compenser le temps nécessaire à la détection du parasite et, d'autre part, de centrer ce parasite dans une fenêtre d'une largeur d'environ 500 µs. Cette ligne à retard 30 se présente sous la forme d'un filtre actif passe-bas 12 pôles de fréquence de coupure 5 KHz par exemple. Ce filtre passe-bas est composé par exemple de six amplificateurs opérationnels (Montage en Source Contrôlée) connectés en cascade, chaque cellule étant d'ordre 2. Le signal retardé est ensuite appliqué au commutateur analogique 31 (Point C).

En absence de "clicks" le signal est transmis au Point D.

En présence de "clicks", le commutateur 31 est ouvert sous la dépendance de la commande 35 (Point J). Dans ce cas, la valeur instantanée du signal BF précédant l'ouverture de l'interrupteur est mise en mémoire 32 et transmise pendant l'ouverture du commutateur analogique ( ≃ 500 µs).

Le parasite a donc été remplacé par un "blanc", ce qui améliore considérablement le confort d'écoute : En effet un blanc d'environ 500 µs n'entraîne aucune gêne à l'écoute.

La mémoire 32 est réalisée par exemple par un condensateur dont la décharge est minimisée par la mise en interface d'un étage à haute impédance d'entrée.

Le signal issu de la fonction mémoire (Point E) est appliqué à un circuit amplificateur 37 : La correction de gain permet d'obtenir entre les Points A et F, en régime sinusoïdal établi, une fonction de transfert de gain unité dans la gamme de fréquence 300-3000 HZ (bande BF).

Au point B est connecté le système de détection. Celui-ci est organisé autour d'un circuit 33 à commande automatique de gain. Les constantes de temps de la boucle d'asservissement de ce circuit sont optimisées pour réguler le signal utile BF et présenter un gain maximal aux parasites se trouvant à l'entrée du circuit : Ceux-ci sont fortement amplifiés dans les limites de la dynamique du circuit. Leurs niveaux respectifs devenant très supérieurs à celui du signal utile, il devient plus facile de les discriminer.

Afin de traiter tous les parasites quelle que soit leur polarité, le circuit détecteur 33 est suivi d'une fonction redresseur double alternance 34. Ce redresseur double alternance 34 est organisé autour d'un amplificateur opérationnel comprenant par exemple deux diodes dans la voie de contre réaction.

Le signal (utile + parasite) est ensuite appliqué au dispositif à seuil 38 comparant le niveau du signal incident à un seuil fixe ; chaque fois qu'un parasite est détecté, la sortie du comparateur (Point K) change d'état et commande la mise en service du circuit monostable (39) qui élabore la commande logique (Point J) du commutateur analogique 31. Ce circuit monostable 39 est redéclenchable et réagit à l'apparition de chaque phénomène parasite. La durée de l'ouverture du commutateur 31 est voisine de 500 µs.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

Ainsi la chaîne de réception de l'art connu, dans laquelle ont été implantés les circuits de mise en oeuvre de l'invention, a été prise uniquement à titre d'exemple.

## Revendications

1. Dispositif d'amélioration du confort d'écoute en présence d'évanouissement de porteuse dans une chaîne de réception d'un équipement FM/PM à bande étroite, notamment en radiotéléphonie, comprenant successivement :
- une tête HF (11) située en sortie d'antenne (10) ;
- au moins un mélangeur (12, 16) recevant un signal oscillateur (OS1, OS2) ;
- un circuit limiteur-amplificateur (17) ;
- un discriminateur (18) ;
- des premiers moyens (23) de régulation du niveau BF du signal reçu ;
- un circuit d'amplification BF (20) ;
caractérisé en ce que ces premiers moyens (23) de régulation du niveau BF comprennent :
- d'une part, entre leur entrée (c) et leur sortie (f), un circuit (40) de régulation de niveau et de filtrage à bande passante adaptative ;
- et d'autre part, entre une entrée de commande (a) et une seconde entrée du circuit de régulation de niveau (40), un circuit (41) de traitement du signal de commande , qui comprend un soustracteur (44) ; l'entrée de commande (a) étant reliée directement à l'une des entrées de ce soustracteur (44), et, après passage dans un intégrateur (45), à une seconde entrée (b) dudit soustracteur (44).

2. Dispositif selon la revendication 1, caractérisé en ce que les moyens (23) de régulation de niveau BF comprennent en outre :
- un circuit séparateur (42) disposé en entrée ;
- un circuit amplificateur (43) disposé en sortie.

3. Dispositif selon l'une quelconque des revendications précédentes, caractérisé en ce qu'il comprend des seconds moyens (22) de détection et d'élimination de phénomènes transitoires, situés en sortie du discriminateur (18) avant les premiers moyens (23) ; ces seconds moyens (22) de détection et d'élimination de phénomènes transitoires permettant de remplacer lesdits phénomènes transitoires par une tension dont la valeur instantanée est celle du signal BF avant détection de ces phénomènes transitoires.

4. Dispositif selon la revendication 3, caractérisé en ce que ces seconds moyens (22) de détection et d'élimination des phénomènes transitoires comprennent :
- d'une part, entre leur entrée (A) et leur sortie (F) au moins un circuit de retard (30), un circuit de commutation (31) et une mémoire (32) ; et
- d'autre part, un circuit de détection (33, 34) de ces phénomènes situé en sortie du discriminateur et une logique de commande (35) recevant le signal dudit circuit de détection (33, 34) et commandant ledit circuit de commutation (31).

## Claims

1. Device for enhancing listener comfort in the presence of carrier fading in a narrow-band FM/PM equipment receive subsystem, especially in radiotelephony, comprising in succession:
- an HF tuner head (11) connected to the output of an antenna (10);
- at least one mixer (12, 16) receiving an oscillator signal (OS1, OS2);
- a limiter-amplifier circuit (17);
- a discriminator (18);
- received signal AF level regulator first means (23);
- an AF amplifier circuit (20);
characterised in that said AF level regulator first means (23) comprise:
- between their input (c) and their output (f) a level regulator and adaptive bandwidth filter circuit (40); and
- between a control input (a) and a second input of the level regulator circuit (40) a control signal processor circuit (41) which comprises a subtractor (44); the control input (a) being connected direct to one input of said subtractor (44) and via an integrator (45) to a second input of said subtractor (44).

2. Device according to claim 1 characterised in that the AF level regulator means further comprise:
- a separator circuit (42) at its input;
- an amplifier circuit (43) at its output.

3. Device according to either of the preceding claims characterised in that it comprises transient phenomena detection and elimination second means (22) on the output side of the discriminator (18) and on the input side of the first means (23); said transient phenomena detection and elimination second means (22) enabling replacement of said transient phenomena by a voltage whose instantaneous value is that of the AF signal before said transient phenomena are detected.

4. Device according to claim 3 characterised in that said transient phenomena detection and elimination second means (22) comprise:
- between their inputs (A) and their output (F) at least one time-delay circuit (30), a switch circuit (31) and a memory (32); and
- a transient phenomena detector circuit (33, 34) on the output side of the discriminator, and control logic (35) receiving the signal from said detector circuit (33, 34) and controlling said switch circuit (31).

## Patentansprüche

1. Die Erfindung betrifft eine Einrichtung zur Verbesserung des Hörkomforts bei Trägerschwund in einer Empfangskette eines Schmalband-FM/PM-Gerätes, insbesondere im beim Funktelefon, die nacheinander aufweist:
- ein HF-Kopf (11) am Ausgang der Antenne (10);
- mindestens einen Mischer (12, 16), der ein Oszillatorsignal (OS1, OS2) empfängt;
- einen Begrenzer-Verstärker (17);
- einen Diskriminator (18);
- erste Mittel (23) zum Regeln des Niederfrequenz-Pegels des Empfangssignals;
- eine Niederfrequenz-Verstärkerschaltung (20);
dadurch gekennzeichnet, daß diese ersten Mittel (23) zur Regelung des Niederfrequenz-Pegels umfassen:
- einerseits eine zwischen ihren Eingang (c) und ihren Ausgang (f) angeschlossene Schaltung (40) zur Regelung des Pegels und zur Filterung mit anpaßbarem Durchlaßband; und
- andererseits eine zwischen einen Steuerspannungseingang (a) und einen zweiten Eingang (b) der Schaltung (40) zur Regelung des Pegels angeschlossene Schaltung (41) zur Bearbeitung des Steuersignals, wobei der Steuereingang (a) direkt an einen der Eingänge des Subtrahierglieds (44), und nach dem Durchgang durch einen Integrator (45) an einen zweiten Eingang des Subtrahierglieds (44) angeschlossen ist.

2. Einrichtung nach Anspruch 1, dadurch gekennzeichnet, daß die Mittel (23) zur Regelung des Niederfrequenz-Pegels weiter aufweisen:
- eine Trennschaltung (42) am Eingang,
- eine Verstärkerschaltung (43) am Ausgang.

3. Einrichtung nach einem beliebigen der vorhergehenden Ansprüche, dadurch gekennzeichnet, daß sie zweite Mittel (22) zur Erfassung und Eliminierung von vorübergehende Erscheinungen aufweist, die am Ausgang des Diskriminators (18) vor den ersten Mitteln (23) angeordnet sind, wobei die zweiten Mittel (22) zur Erfassung und Eliminierung der vorübergehenden Erscheinungen das Ersetzen dieser vorübergehenden Erscheinungen durch eine Spannung ermöglichen, deren Momentanwert demjenigen des Niederfrequenz-Signals vor der Erfassung der vorübergehenden Erscheinungen entspricht.

4. Einrichtung nach Anspruch 3, dadurch gekennzeichnet, daß die zweiten Mittel (22) zur Erfassung und Eliminierung der vorübergehenden Erscheinungen aufweisen:
- einerseits zwischen ihrem Eingang (A) und ihrem Ausgang (F) mindestens eine Verzögerungsschaltung (30), einen Schalter (31) und einen Speicher (32), und
- andererseits eine Schaltung (33, 34) zur Erfassung dieser Erscheinungen, die hinter dem Diskriminator angeordnet ist, und eine Steuerlogik (35), die das Signal der Erfassungsschaltung (33, 34) empfängt und den Schalter (31) steuert.
